Europäisches Patentamt

European Patent Office

Office européen des brevets

(11) Publication number: **0 464 837 A2**

# EUROPEAN PATENT APPLICATION

(21) Application number: **91111196.1**

(22) Date of filing: **05.07.91**

(51) Int. Cl.5: **H01L 21/76**

(30) Priority: **05.07.90 JP 177883/90**

(43) Date of publication of application:
**08.01.92 Bulletin 92/02**

(84) Designated Contracting States:
**DE FR GB**

(71) Applicant: **KABUSHIKI KAISHA TOSHIBA**
**72, Horikawa-Cho Saiwai-ku**
**Kawasaki-shi Kanagawa-ken(JP)**

(72) Inventor: **Hoshi, Tadahide**
**6-25-205, Toyooka-Cho, Tsurumi-Ku**
**Yokohama-Shi, Kanagawa-Ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Method of manufacturing semiconductor substrate using semiconductor integrated circuit having dielectric separation structure.

(57) The method of manufacturing a semiconductor substrate comprises an adhesion step of forming a laminated substrate by mirror polishing one surface each of a first and second semiconductor substrates (25, 27), and by bringing the two polished surfaces into contact and adhering both substrates (25, 27); a rough grinding step of roughly grinding to a predetermined thickness of a substrate surface on the side of the both surfaces of the laminated substrate, on which a required semiconductor layer (30) is formed; an etching step of removing process distortion due to rough grinding of the substrate (25, 27) that has had the side of one surface roughly polished by the rough grinding step; and a mirror polishing step of mirror polishing a substrate surface on the side (25) of the formation of the required semiconductor layer (30) in the laminated substrate after the process distortion has been removed, and for the formation of the required semiconductor layer; and furthermore prior to at least the etching step, a dielectric layer formation step of forming a dielectric layer (29) on another surface on the side (27) of the required semiconductor layer formed in the laminated substrate, for protecting the other surface, during the etching step.

FIG. 4A

## BACKGROUND OF THE INVENTION

The present invention relates to a method for the manufacture of a semiconductor substrate, and more particularly, to a method for the manufacture of an adhered semiconductor substrate having a semiconductor layer having a good accuracy of a required thickness.

Conventionally, when circuit elements of semiconductor integrated circuits were formed, forming circuit elements that were islands separated from other circuit elements involved the use of the dielectric separation structure where the structure had, for example, a periphery portion (of side surfaces and a bottom surface) completely surrounded by a dielectric body.

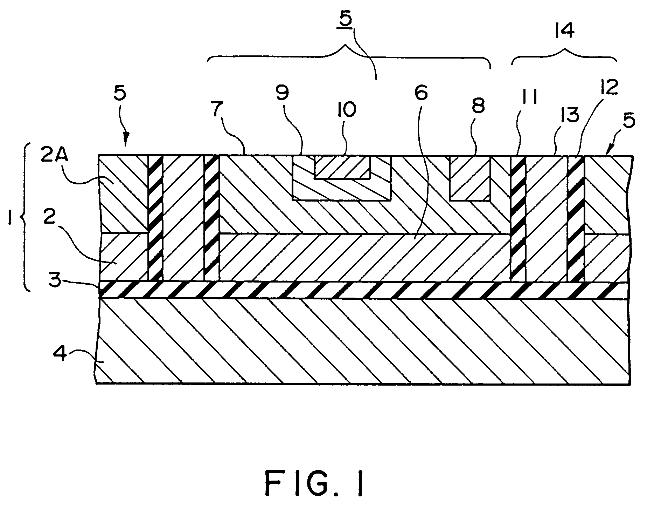

FIG. 1 shows a sectional view of one example of a semiconductor device that has such as dielectric separation structure. More specifically, numeral 1 is a first semiconductor substrate having a semiconductor layer 2 as a semiconductor active layer on the side of the topmost layer, and an insulation layer (SiO$_2$) 3 to the side of the bottom layer. Numeral 4 is a second semiconductor substrate which is adhered so as to form the bottom layer of the insulation layer 3. The main portions of the circuit elements 5 are formed on the semiconductor layer 2 and an upper layer 2A thereof so as to form a high-concentration n-type silicon layer 6, on the semiconductor layer 2, and a low-concentration silicon layer 7 on this upper layer 2A.

In addition, to the upper surface portion of the low-concentration silicon layer 7 are formed an n-type impurity diffusion layer 8 and a p-type impurity dispersal layer 9 at a distance from each other, and to the upper surface portion of the p-type impurity diffusion layer 9 is formed an n-type impurity diffusion layer 10. Then, the circuit element 5 is separated by the insulation layer 3 on the bottom surface, and are separated from the other circuit elements by a groove provided in each of the four side surfaces. In other words, the circuit element 5 is surrounded by an insulation film (SiO$_2$) 11 and 12 along both side surfaces of the groove in all four directions, and a polycrystal silicon layer 13 is formed inside the surrounded grooves so that a structure 14 like a wall where a polycrystal silicon layer exists inside an insulation film separates the circuit element 5 from other circuit elements.

One particularly important factor for semiconductor substrates when forming a semiconductor device having such a dielectric separation structure, is that the layer thickness of the semiconductor substrate 2 be accurately formed to a uniform thickness. For example, if the required thickness of 1.5 $\mu$m, then it is desirable that the difference from the required thickness be under ± 0.5 $\mu$m. If there is a poor accuracy of thickness of the semiconductor layer 2, then the sheet resistance of the high-concentration n-type silicon layer 6 will not be uniform, or otherwise it will not be possible to ensure a sufficient thickness of the groove in all for directions so as to separate the circuit elements and so the elements may not be perfectly separated and there will be conductivity between elements and associated influences.

Conventionally, the method described below has been used to manufacture such a semiconductor substrate.

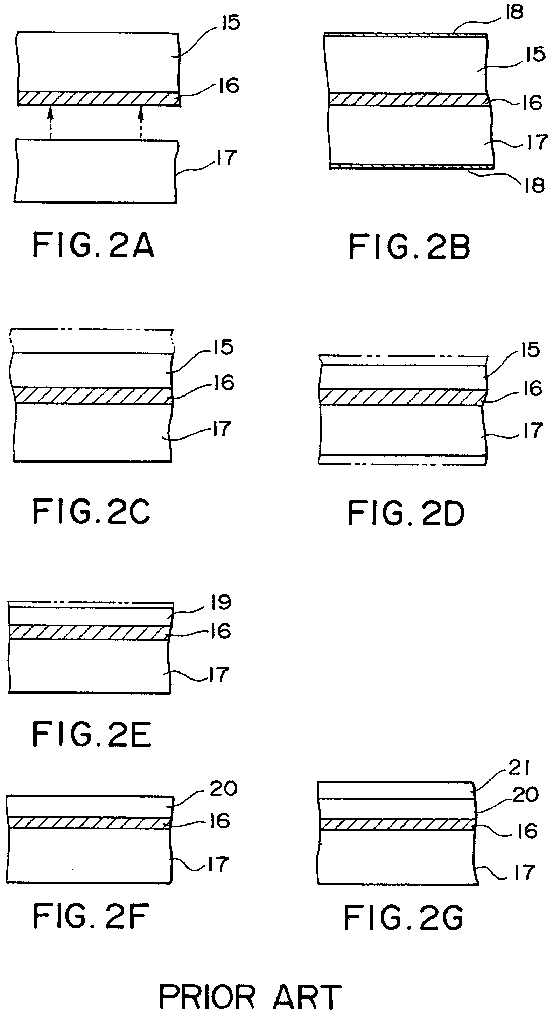

FIGS. 2A through 2G show the order of the manufacturing processes, and FIG. 2A shows an oxidation step for a first silicon substrate, with the surface of a first silicon substrate 15 comprising an n-type silicon substrate being oxidized to form an oxide layer 16 of silicon dioxide (SiO$_2$). Numeral 17 is a second silicon substrate and its upper surface is formed to a high degree of flatness (TTV ≤ 1 $\mu$m). FIG. 2B shows an adhesion step where the lower surface of the oxide layer 16 of the first silicon substrate and the upper, highly flat surface of the second silicon substrate are brought into contact, heat processing implemented and both substrates adhered to each other. Moreover, when there is the heat processing to solidify the adhesive, there are instances when a thin oxide film 18 is formed on the substrate surface because of the processing conditions. FIG. 2C shows a rough grinding step where the upper surface of the first silicon substrate 15 that was obtained by adhesion in the prior process after the thin oxide film 18 was removed, is roughly ground to a required thickness by a grinder or the like. FIG. 2D shows a process distortion removal step which involves the use of an HF-HNO$_3$ or KOH etching solution to remove the process distortion caused by the rough grinding of the substrate. FIG. 2E shows a polishing step which involves non-distortion mirror polishing of the upper surface of the first silicon substrate 15 of the substrate that has had the process distortion removed, and the formation of a semiconductor layer 19 having a required thickness.

Moreover, the steps shown in FIGS. 2F and 2G are for the further formation of the semiconductor layer 19 as a semiconductor active layer, and are a diffusion step for the diffusion of high-concentration n-type impurities in the semiconductor layer 19 and for the formation of a high-concentration n-type silicon layer 20, and an epitaxial growth step for the formation by epitaxial growth of a low-concentration n-type silicon layer 21 on the high-concentration n-type silicon layer 20.

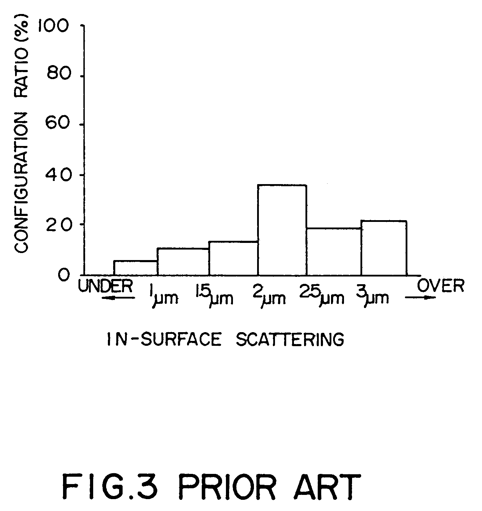

In a conventional semiconductor substrate formed by this manufacturing method, despite the fact that a substrate having a high degree of flatness (TTV ≤ 1 $\mu$m) is used as the silicon substrate to the second silicon substrate 17, there is a large scattering for the thickness of the semiconductor layer 19 in the steps after the polishing step. This is to say that if the thickness of the semiconductor layer 19 is measured after it has been supposedly polished to a required thickness of 1.5 $\mu$m is measured, then as shown in FIG. 3, the surface thickness scattering reaches an average of 2 to 3 $\mu$m and the yield having a scattering of 1 $\mu$m or less is about 5%, so that there is the problem of mass producing semiconductor substrates that have a semiconductor layer with a high accuracy of thickness.

## SUMMARY OF THE INVENTION

In the light of the problems described above, an object of the present invention is to provide a method for the manufacture of a semiconductor substrate so that the thickness of the semiconductor layer formed on an adhered semiconductor substrate has a good accuracy to a required thickness, and so that there is a high yield in mass production.

The method of manufacture of a semiconductor substrate of the present invention involves, mutually adhering each of the surfaces of the first and second semiconductor substrates that have been mirror polished, and then rough grinding the other surface of the first semiconductor substrate, and then performing the process distortion removal etching, and then mirror polishing another surface of the first semiconductor substrate and forming the semiconductor layer to a required thickness between the adhered portion of the first semiconductor substrate, and then providing a dielectric layer to the upper surface of another surface of the second semiconductor substrate and performing process distortion removal etching.

The method of manufacturing a semiconductor substrate having the configuration described above involves providing a dielectric layer to the upper surface of another surface of the second semiconductor substrate and performing process distortion removal etching so that shape changes in the other surface of the second semiconductor substrate and that becomes the processing reference surface in the processing process, and in particular, shape changes that occur when there is the process distortion removal etching are suppressed, so that there is a good accuracy to the required thickness of the semiconductor substrate that is formed on the contact portion of the first semiconductor substrate, and there is a high yield in mass production.

As is clear from the description above, the present invention forms a semiconductor layer to a required thickness on an adhered semiconductor substrate, and involves performing process distortion removal etching for the other surface of the second semiconductor substrate so that there is a good accuracy to the required thickness of the semiconductor substrate that is formed on the contact portion of the first semiconductor substrate, and so that there is a high yield in mass production.

## BRIEF DESCRIPTION OF THE DRAWINGS

In the appended drawings:
FIG. 1 is a sectional view showing a general semiconductor substrate that has a dielectric separation structure;
FIGS. 2A through 2G are step figures showing the order of the manufacturing processes of a conventional semiconductor substrate;
FIG. 3 is a distribution diagram that shows an example of the ratio of the layer thickness distribution of a semiconductor substrate manufactured by the conventional method;
FIGS. 4A through 4F are step diagrams for describing the method of manufacture of a semiconductor substrate according to a first embodiment of the present invention;
FIG. 5 is a distribution diagram showing the layer thickness distribution of a semiconductor substrate manufactured according to the processes shown in FIGS. 4A through 4F;
FIGS. 6A through 6E are step diagrams for describing the method of manufacturing a semiconductor substrate according to a second embodiment of the present invention;
FIGS. 7A through 7E are step diagrams for describing the method of manufacturing a semiconductor substrate according to a third embodiment of the present invention; and
FIGS. 8A through 8H are step diagrams for describing the method of manufacturing a semiconductor substrate according to a fourth embodiment of the present invention.

## DETAILED DESCRIPTION OF THE PREFERRED EMBODIMENTS

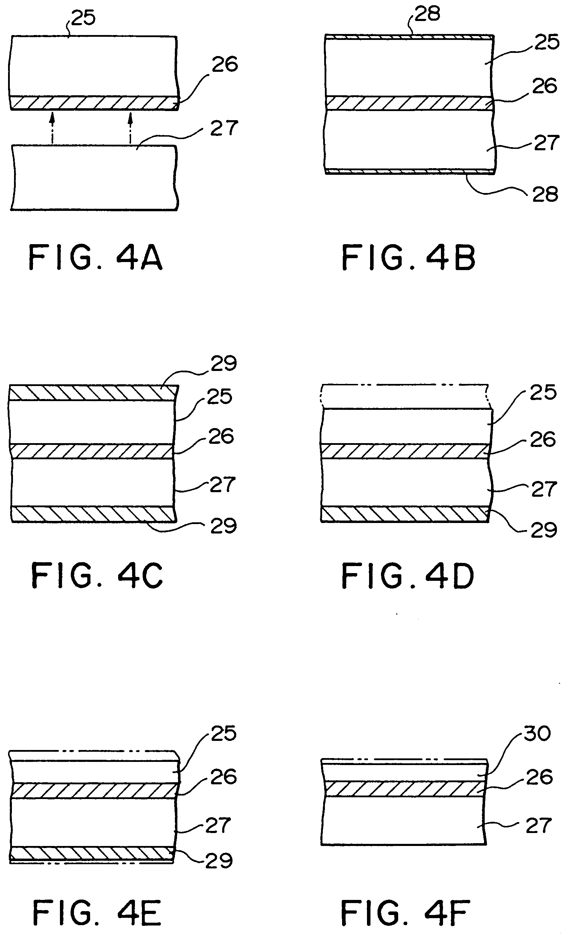

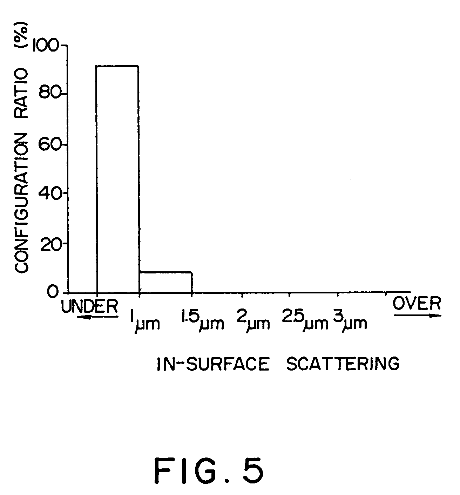

The following is a detailed description of a first embodiment of the present invention, with reference to FIGS. 4A through 4F and FIG. 5.

FIGS. 4A through 4F are step diagrams showing steps of a semiconductor substrate that has a dielectric separation structure, and FIG. 5 is a layer thickness distribution diagram of the semiconductor layer.

FIG. 4A shows an oxidation step of the first silicon substrate. An n-type silicon substrate has a first silicon substrate 25 comprising its surface having a diameter of 125 mm, a thickness of 625 $\mu$m and a specific resistance of 1 to 2 $\Omega \cdot$cm oxidized, for example, and a first dielectric layer 26 of silicon

dioxide (SiO$_2$) formed to a thickness of 1 $\mu$m on the mirror polished surface. Moreover, numeral 27 is a second silicon substrate, and for example, is formed by an n-type silicon substrate that has a diameter of 125 mm, a thickness of 625 $\mu$m and a specific resistance of 5 to 10 $\Omega \cdot$cm mirror polished to a high degree of flatness (TTV $\leqq$ 1 $\mu$m).

FIG. 4B shows an adhesive step in atmosphere and at room temperature, of respective mirror polished surfaces the lower surface of the first dielectric layer 26 and the upper highly flat surface of the second silicon substrate 27. After this, the substrate is subjected to heat processing for two hours at a temperature of 1100$^\circ$C in an atmospheric gas having N$_2$:O$_2$ ratio of 4:1, and for the adhesion of the first and second silicon substrates.

Then, in order to remove the unadhered portion around the periphery of the adhered substrate, the outer peripheral portion of the adhered substrate is physically polished, after the thin oxide film 28 of silicon dioxide (SiO$_2$) that is formed by heat processing when there is adhesion is removed, and the substrate diameter made 100 mm.

In FIG. 4C showing an oxidation step, the substrate that has been formed to a diameter of 100mm in the prior step has heat processing implemented for three hours at a temperature of 1100$^\circ$C in an atmosphere of H$_2$:O$_2$ = 1:1 (volume ratio), and this substrate is covered by a second dielectric layer 29 of silicon dioxide (SiO$_2$) to a thickness of 1 $\mu$m for example, to remain to more than a required thickness for the following processes, and particularly in the process distortion removal step performed after etching.

In FIG. 4D showing a rough grinding step, the upper surface of the first silicon substrate 25 of the substrate that was covered by the second dielectric film 29 in the prior process is roughly ground using a grinder or the like until the thickness of the first dielectric layer 26 is approximately 25 $\mu$m. Moreover, the second dielectric layer 29 of the lower surface of the second silicon substrate 27 remains as it is.

In FIG. 4E showing a process distortion removal step, an HF-HNO$_3$ system etching liquid is used to etch approximately 10 $\mu$m for both sides to remove the process distortion due to the rough grinding of the substrate that was roughly ground in the prior step. The second dielectric layer 29 that also has the process distortion removed is etched but remains as it is even after this process. Moreover, the amount of removal of the process distortion is increased or reduced by the amount of rough grinding in the prior step, and is determined by by the required amount.

In FIG. 4F, a polishing step for the upper surface of the first silicon substrate 25 of the substrate that has had the process distortion removed in the prior step, after the second dielectric layer 29 that covers the second silicon substrate 27 is completely removed, is normally termed mechano-chemical polishing for normal silicon substrates and is performed to a non-distorting mirror surface where the average thickness in the center of the substrate becomes 1.5 $\mu$m and give the required semiconductor substrate 30. These steps described above form a semiconductor substrate 30 having a required thickness.

Twenty five sample semiconductor substrates relating to the first embodiment of the present invention were then manufactured using these steps. FIG. 5 shows the results of measurement of the layer thickness of the sample semiconductor substrates. The figure is a layer thickness distribution diagram where the horizontal axis is the scattering within the surface, and the vertical axis is the configuration ratio.

As is clear from this figure, the semiconductor substrate of this embodiments has a small in-surface scattering of the layer thickness. The average width of the in-surface scattering was 0.87 $\mu$m and the yield with a scattering of 1 $\mu$m or less was 92%.

On the contrary, by way of comparison, of those of the above processes, the rough grinding process in FIG. 4D that roughly grinds the upper surface of the first silicon substrate so that the thickness on the first dielectric layer 26 becomes approximately 25 $\mu$m, is followed by the removal of the second dielectric layer 29 by etching, and then by (shown in FIG. 4E) the process distortion removal processes to manufacture 25 sample semiconductor substrates using techniques the same as conventional ones shown in FIG. 2. FIG. 3 shows the results of measurements of the layer thickness of the sample semiconductor layers used for comparison. In the figure, the horizontal axis is the scattering within the surface, and the vertical axis is the configuration ratio.

According to this, there is a large width of the scattering inside the surface of the layer thickness of the semiconductor layer, and the average width of this in-surface scattering is 2.5 $\mu$m and the yield with a scattering of 1 $\mu$m or less was 5%. In this manner, there is a large difference in the scattering of the thickness of the semiconductor layer between this embodiment and the conventional example, and in a semiconductor substrate relating to this embodiment has a small in-surface scattering and a higher accuracy of layer thickness so that a stable and high yield can be realized and this is suited to mass producing. In addition, the semiconductor device having a dielectric body separation layer as described above is suited to mass production.

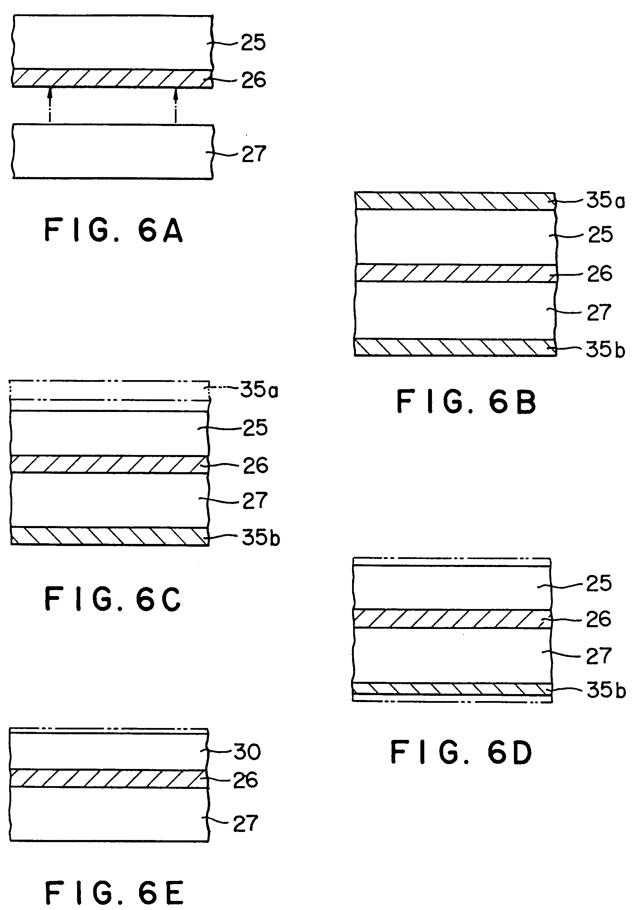

Moreover, in the first embodiment described above, the formation of the second dielectric layer 29 to a required thickness to the lower surface of the second silicon substrate 27 is performed after the removal and formation of the outer peripheral portion of the adhered substrate. However, the present invention is not limited to this as for example, the conditions can be provided at the same time as the heat processing in the adhesion step and the oxide layers 35a and 35b that become the second dielectric layer of required thickness can be formed in accordance with a second embodiment shown in FIGS. 6A through 6E. Moreover, FIG. 6C shows a rough grinding step, wherein the surface of the silicon substrate 25 and the oxide layer 35a on the first silicon substrate 25 are roughly ground. FIG. 6D shows a process distortion removal step, and the process distortion of the substrate that has been formed in the rough grinding step in FIG. 6C, is removed by etching using an etching liquid of an HF-HNO$_3$ series. Following this, the oxide layer 35b of the side of the second silicon substrate 27 is completely removed. FIG. 6E shows a mirror polishing step that follows, and the surface of the first silicon substrate 25 is polished to a non-distorting mirror surface by the mechanical grinder, for example.

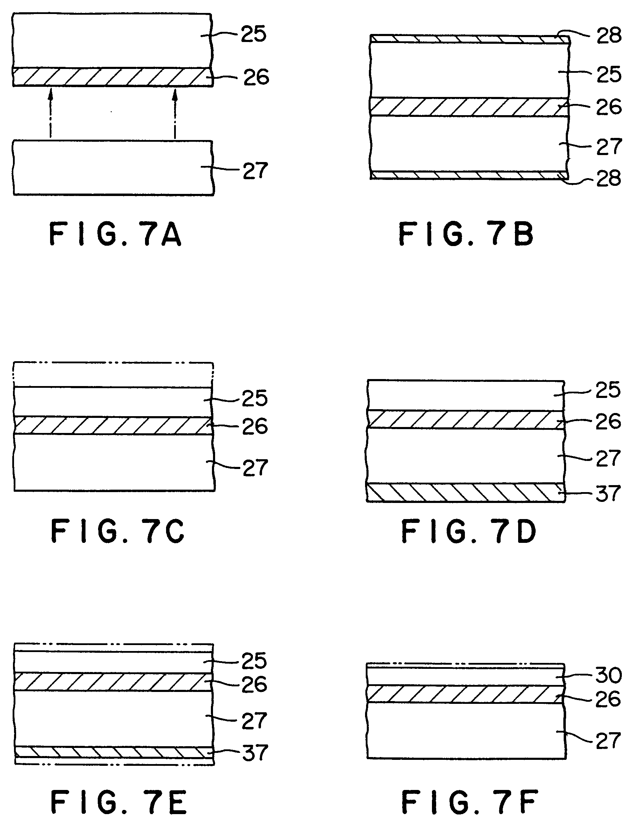

In addition, the previously described first or second embodiments were described for the oxidation step (FIG. 4C or 6B) being performed prior to the rough grinding process (FIG. 4D or 6C) but the present invention is not limited to this. The important point of this invention is that a dielectric layer is formed on the exposed surface of the second substrate 27 while etching to remove the process distortion is being performed and so a substrate that is formed by the steps such as those for a third embodiment shown in FIGS. 7A through 7F can be used.

More specifically, in the oxidation step shown in FIG. 7A, one of the surfaces of the first silicon substrate 25 is oxidized and a first dielectric layer 26 of silicon dioxide (SiO$_2$) is formed. One of the surfaces of the second silicon substrate 27 and the surface of the side of the first dielectric layer 26 of the first silicon substrate 25 are joined after they have been mirror surface polished. The two joined substrates 25 and 27 are securely adhered by thermal processing in the adhesion step shown in FIG. 7B. By this processing, the surfaces of the first and second substrate 25 and 27 have the thin oxide films 28 and 28 formed on them and so these thin oxide films 28 and 28 are removed. Then, in a rough grinding step shown in FIG. 7C, the grinding of the surface of the exposed side of the first substrate 25 is performed to a required thickness. Moreover, when this rough grinding is performed, the surface on the other side of the second substrate 27 is stilled exposed. Then, in the dielectric layer formation step, the oxide layer 37 shown in FIG. 7D is formed as the second dielectric layer to a required thickness by the chemical vapor deposition (CVD) method. Then, in a process distortion removal step shown in FIG. 7E, in the same manner as for the first and second embodiments, an HF-HNO$_3$ series etching liquid is used to etch both sides of the substrate by approximately 10 $\mu$m so that the process distortion of the substrate is removed, and after this the oxide layer 37 is completely removed. FIG. 7F shows a mirror surface polishing step, and in the same manner as for the first and second embodiments (FIG. 4F and 6E), mechanical and chemical polishing is used to polish the substrate to a non-distorting mirror surface and obtain the required semiconductor layer 30.

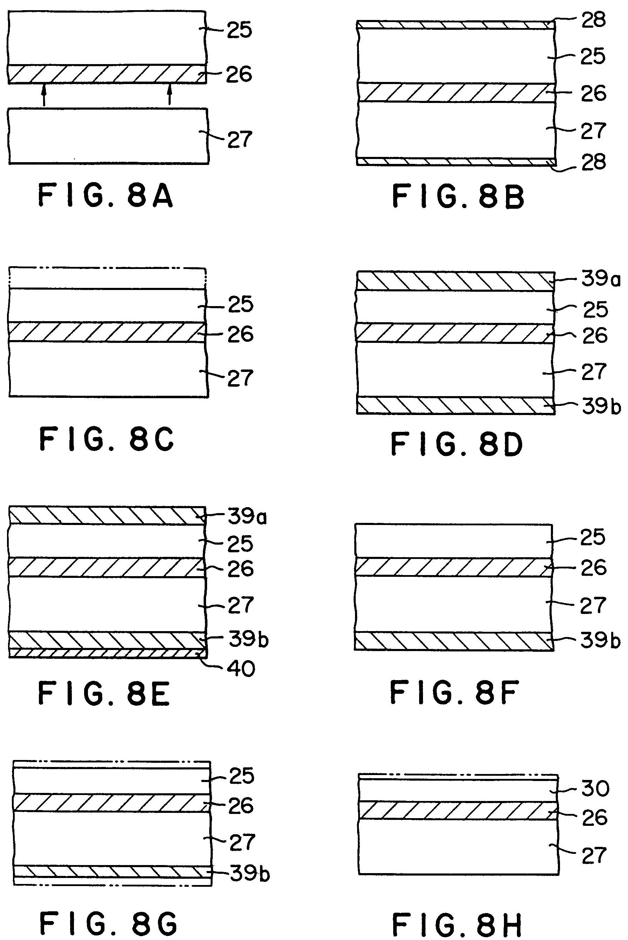

Moreover, in the method of manufacturing a semiconductor substrate according to the third embodiment as has been described above, the second dielectric layer formation step was described as the oxide film 37 being formed by the CVD method but the present invention is not limited to this, as for example, the oxide film can be formed by thermal oxidation as in the case of a fourth embodiment. More specifically, in FIGS. 8A through 8H for describing the fourth embodiment, FIG. 8A shows an oxidation step of forming the first dielectric layer 27, FIG. 8B shows a thermal processing step for the secure adhesion of the two silicon substrates 25 and 27, and FIG. 8C shows a rough grinding step of roughly grinding one surface of the first silicon substrate 25, and these figures correspond to FIGS. 7A through 7C. In the third embodiment, the dielectric layer formation step for the second layer by the CVD method as shown in FIG. 7D, is performed by the steps shown in FIGS. 8D through 8F in the fourth embodiment. FIG. 8D shows the thermal oxidation step and in this step, the oxide layers 39a and 39b having the required thickness are formed as the second dielectric layer to the exposed surfaces of the first and second silicon substrates 25 and 27. After this, in a resist film formation step shown in FIG. 8E, a resist film 40 that is comparatively thin is formed on the oxide layer 39b so as to protect the oxide layer 39b of the side of the second substrate. After this, in an etching step shown in FIG. 8F, the performance of etching to remove the oxide layer, causes only the oxide layer 39b that is protected by the resist film 40 to remain, and the oxide layer 39a of the side of the first substrate 25 is removed by the etching. After this, a process distortion removal step, a mirror surface polishing step and the like are the same as those for the second and third embodiments as shown in FIGS. 6D and 6E, and in FIGS. 7E and 7F, and so these steps are only indicated in FIGS. 8G and 8H and a detailed description of them is omitted here.

Furthermore, in the embodiment described above, the description was given for when an adhered silicon substrate having a first dielectric body layer 26 was disposed at the adhesion portion between the first silicon substrate 25 which is the first silicon substrate and the second silicon substrate 27 which is the second silicon substrate but it is not necessary to provide a dielectric body layer at the adhesion portion, as an adhered semiconductor substrate can be formed by directly adhering a first and a second semiconductor substrate, or some other suitable modification can be performed without departing from the scope of the present invention.

Reference signs in the claims are intended for better understanding and shall not limit the scope.

**Claims**

1. A method of manufacturing a semiconductor device, comprising:

   an adhesion step of forming a laminated substrate by means of mirror polishing one surface each of a first and second semiconductor substrates (25, 27), and by bringing said two polished surfaces into contact and adhesing both substrates (25, 27);

   a rough grinding step of roughly grinding to a predetermined thickness of a substrate surface on the side of said both surfaces of said laminated substrate, on which a required semiconductor layer (30) is formed;

   an etching step of removing process distortion due to rough grinding of said substrate (25, 27) that has had the side of one surface roughly polished by said rough grinding step; and

   a mirror polishing step of mirror polishing a substrate surface on the side (25) of the formation of said required semiconductor layer (30) in said laminated substrate after the process distortion has been removed, and for the formation of said required semiconductor layer; and furthermore

   prior to at least said etching step, a dielectric layer formation step of forming a dielectric layer (29, 35b, 37, 39b) on another surface on the side (27) of said required semiconductor layer (30) formed in said laminated substrate, for protecting said other surface, during said etching step.

2. The method of manufacturing a semiconductor substrate according to claim 1, wherein

   said adhesion step comprises an oxidation step of forming another dielectric layer different from said dielectric layer (29, 35b, 37, 39b) by the oxidation of a contact surface of one substrate of said first and second semiconductor substrates (25, 27); a polishing step of mirror polishing both said surfaces of said another dielectric layer (26) and said other substrate of said two opposing substrates; and a thermal processing step of applying a contact temperature which surfaces of two substrates that have been mirror polished are in contact, and chemically adhering said surfaces completely.

3. The method of manufacturing a semiconductor substrate according to claim 2, wherein

   said thermal processing is performed by leaving said contacted substrate under temperature conditions within a range of 600-1200 degrees centigrade, and more desirably within 1000-1200 degrees centigrade.

4. The method of manufacturing a semiconductor substrate according to claim 2, wherein

   said substrate is manufactured by the order of said adhesion step, said dielectric layer formation step, said rough grinding step, said etching step and said mirror polishing step, in sequence.

5. The method of manufacturing a semiconductor substrate according to claim 4, wherein

   said dielectric layer formation step is performed continuously and simultaneously with said thermal processing step in said adhesion step, and said dielectric layer (35b) is formed to a required thickness at the same time as two substrates in contact are chemically and completely adhered.

6. The method of manufacturing a semiconductor substrate according to claim 1, wherein

   said dielectric layer formed on said other surface of said laminated substrate by said dielectric layer formation step, remains on at least said other surface while process distortion due to rough grinding is removed by etching.

7. The method of manufacturing a semiconductor substrate according to claim 1, wherein

   said substrate is manufactured by the order of said adhesion step, said dielectric layer formation step, said rough grinding step, said etching step, and said mirror polishing step, in sequence.

8. The method of manufacturing a semiconductor substrate according to claim 1, wherein

   said substrate is manufactured by the order of said adhesion step, said rough grinding step, said dielectric layer formation step, said etching step, and said mirror polishing step, in sequence.

FIG. 1

FIG.2A

FIG.2B

FIG.2C

FIG.2D

FIG.2E

FIG.2F

FIG.2G

PRIOR ART

FIG.3 PRIOR ART

FIG. 4A

FIG. 4B

FIG. 4C

FIG. 4D

FIG. 4E

FIG. 4F

FIG. 5

FIG. 6A

FIG. 6B

FIG. 6C

FIG. 6D

FIG. 6E

FIG. 7A

FIG. 7B

FIG. 7C

FIG. 7D

FIG. 7E

FIG. 7F

FIG. 8A

FIG. 8B

FIG. 8C

FIG. 8D

FIG. 8E

FIG. 8F

FIG. 8G

FIG. 8H